Europäisches Patentamt

European Patent Office

Office européen des brevets

(11) Numéro de publication : **0 434 493 B1**

(12) **FASCICULE DE BREVET EUROPEEN**

(45) Date de publication du fascicule du brevet :
22.06.94 Bulletin 94/25

(51) Int. Cl.⁵ : **B06B 1/06, H01L 41/08**

(21) Numéro de dépôt : **90403484.0**

(22) Date de dépôt : **07.12.90**

(54) **Procédé pour augmenter la puissance des transducteurs électro-acoustiques à basse fréquence et transducteurs correspondants.**

(30) Priorité : **07.12.89 FR 8916172**

(43) Date de publication de la demande :
**26.06.91 Bulletin 91/26**

(45) Mention de la délivrance du brevet :
**22.06.94 Bulletin 94/25**

(84) Etats contractants désignés :
**DE ES GB IT SE**

(56) Documents cités :
**US-A- 2 988 728**
**US-A- 3 183 378**
**US-A- 3 495 102**

(73) Titulaire : **ETAT-FRANCAIS représenté par le DELEGUE GENERAL POUR L'ARMEMENT**
**26, Boulevard Victor**
**F-00460 Armées (FR)**

(72) Inventeur : **Boucher, Didier M.**
**Le Saint Michel,**
**Bât. C.,**
**Rue Brunette**
**F-83140 Six Fours Les Plages (FR)**

EP 0 434 493 B1

Jouve, 18, rue Saint-Denis, 75001 PARIS

## Description

La présente invention concerne des procédés pour augmenter la puissance des transducteurs électro-acoustiques à basse fréquence ainsi que les transducteurs obtenus par ces procédés.

Le secteur technique de l'invention est celui de la construction des transducteurs électro-acoustiques, (piézo-électriques ou magnétostrictifs), utilisés pour construire des émetteurs d'ondes acoustiques utilisés comme émetteurs de sonars.

A ce jour, la plupart des émetteurs de sonar de puissance élévée en basse fréquence, c'est-à-dire pour des fréquences comprises entre 100 Hz et 10 kHz, comportent un moteur, qui est composé d'un ou plusieurs empilements de plaquettes électro-acoustiques, généralement des céramiques piézo-électriques séparées par des électrodes.

Ainsi, les transducteurs connus sous le nom de Tonpilz comportent un empilement de plaquettes identiques, qui sont placées entre un pavillon et une contremasse et gui sont traverséees par une tige qui relie le pavillon à la contremasse et qui est mise sous tension pour maintenir les plaquettes comprimées.

On connaît également des transducteurs dits "flextensional" qui comportent un ou plusieurs empilements de plaquettes électro-acoustiques identiques disposés suivant le grand axe d'une enveloppe ayant une section de forme elliptique.

La plupart du temps, les plaquettes composant un empilement sont des anneaux de céramique piézo-électrique ,de surface latérale plane, qui sont séparés par des électrodes, de sorte que l'empilement a la forme d'un cylindre droit ayant une section circulaire. Dans les brevets US A 2988728 et US A 3495102, on présente des empilements de plaques circulaires ou annulaires qui sont chanfreinées dans le but de mieux répartir les contraintes et d'augmenter la distance entre les électrodes afin de diminuer le risque de claquage.

Quelque soit la forme géometrique des plaquettes, chanfreinées ou pas,le dimensionnement de l'empilement est réalisé principalement en déterminant le nombre et les dimensions (épaisseur et diamètre) des plaquettes de telle sorte que la fréquence considérée soit égale à la fréquence de résonance de l'empilement.
Cependant, pour ce type de dimensionnement,les conditions nécessaires pour obtenir une basse fréquence de résonance sont contradictoires avec celles exigées pour obtenir une forte puissance d'émission, ce qui ne permet pas de réaliser des transducteurs de forte puissance.

En effet, la fréquence de résonance F d'un empilement est de la forme :

$$F = \frac{1}{2\pi\sqrt{exm}}$$

formule dans laquelle e représente l'élasticité et m la masse de l'empilement. La masse m étant limitée par des contraintes de poids et d'encombrement à ne pas dépasser, le facteur sur lequel on peut agir est donc l'élasticité e de l'empilement.

Or, l'élasticité :

$$e = \frac{L}{Y \times S}$$

formule dans laquelle Y est le module d'Young, L la longueur et S la surface de contact entre les plaquettes qui est égale à la section transversale des plaquettes.

La longueur L étant également limitée par des contraintes d'encombrement à ne pas dépasser, le facteur sur lequel on peut agir pour réduire la fréquence de résonance en augmentant l'élasticité est donc la section S qui doit être réduite.

La puissance acoustique Pa émise par un empilement de plaquettes en céramique piézo-électrique s'exprime par la formule suivante $Pa = V.w.E^2.k^2.\varepsilon.Qm$, formule dans laquelle V est le volume de l'empilement, w la pulsation correspondant à la fréquence, E le champ électrique appliqué à l'empilement qui est limité par la tension maxima admise, k le coefficient de couplage électromécanique de la céramique qui dépend de la nature du matériau, $\varepsilon$ la constante diélectrique de la céramique et Qm un facteur de qualité qui dépend de la largeur de la bande passante et qui est donc imposé par le choix de cette largeur.

Cette formule montre que le volume V de l'empilement est un des facteurs sur lequel on peut agir pour augmenter la puissance émise.

Dans le cas d'un barreau cylindrique droit, le volume V est égal au produit de la longueur par la section transversale.

Comme on l'a déjà expliqué,la longueur maxima L est limitée pour des raisons d'encombrement.

Si l'on augmente la section transversale S, on augmente la puissance émise, mais comme on l'a expliqué précédemment, on réduit l'élasticité de l'empilement et on augmente donc la fréquence de résonance. on voit donc que le choix des dimensions (épaisseur et diamètre des plaquettes) ainsi que leur nombre, ne suffit pas à obtenir à la fois une forte puissance et une basse fréquence d'émission.

L'objectif de la présente invention est de procurer des transducteurs composés d'un empilement de plaquettes électro-acoustiques, piézo-électriques ou magnétostrictives, qui peuvent émettre une forte puissance à basse fréquence.

Cet objectif est atteint par un procédé selon lequel on tronque les arêtes des plaquettes électro-acoustiques composant un empilement, de telle sorte que les surfaces de contact de chaque plaquette avec celles qui lui sont juxtaposées dans l'empilement sont réduites à deux méplats dont la surface est inférieure à la section transversale maxima de chaque plaquette.

De préférence, le rapport entre la surface des méplats de contact et la section transversale maxima des plaquettes est inférieur à 0,8.

Un transducteur électro-acoustique à basse fréquence selon l'invention est du type connu comportant un empilement de plaquettes électro-acoustiques identiques formant un barreau qui vibre longitudinalement lorsqu'il est excité électriquement.

Un transducteur électro-acoustique selon l'invention est caractérisé par le fait que les arêtes dedites plaquettes sont tronquées de telle sorte que les surfaces de contact de chaque plaquette avec celles qui lui sont juxtaposées dans ledit empilement, sont constituées de deux méplats, dont la surface est inférieure à la section transversale maxima desdites plaquettes de telle sorte que la puissance émise par ce transducteur électro-acoustique est augmentée.

L'invention a pour résultat des transducteurs électro-acoustiques, notamment des transducteurs piézo-électriques ou magnétostrictifs, qui peuvent émettre à basse fréquence une puissance supérieure à celle des transducteurs connus à ce jour.

Le gain de puissance peut atteindre 50%. Ce gain est obtenu grâce à un gain de la sensibilité sans augmenter la puissance d'excitation ni le poids ou les dimensions. Au contraire, les troncatures et chanfreins qui caractérisent les transducteurs selon l'invention permettent de diminuer le poids pour une puissance accrue.

La description suivante se réfère aux dessins annexés qui représentent, sans aucun caractère limitatif, des exemples de réalisation de transducteurs électro-acoustiques selon l'invention.

La figure 1 est une vue avec coupes axiales partielles d'un transducteur piézo-électrique connu de type Tonpilz.

La figure 2 est une vue éclatée en perspective d'un transducteur piézo-électrique connu de type dit "flextensional".

La figure 3 est une coupe axiale partielle d'un premier mode de réalisation d'un empilement de plaquettes piézo-électriques d'un transducteur selon l'invention.

La figure 4 est une coupe axiale partielle d'un deuxième mode de réalisation d'un empilement de plaquettes piézo-électriques d'un transducteur selon l'invention.

La figure 5 est une coupe axiale partielle d'un troisième mode de réalisation.

La figure 6 est une vue en perspective d'une plaquette piézo-électrique rectangulaire.

Les figures 7 et 8 sont des diagrammes comparatifs de la sensibilité d'un transducteur connu et d'un transducteur selon l'invention.

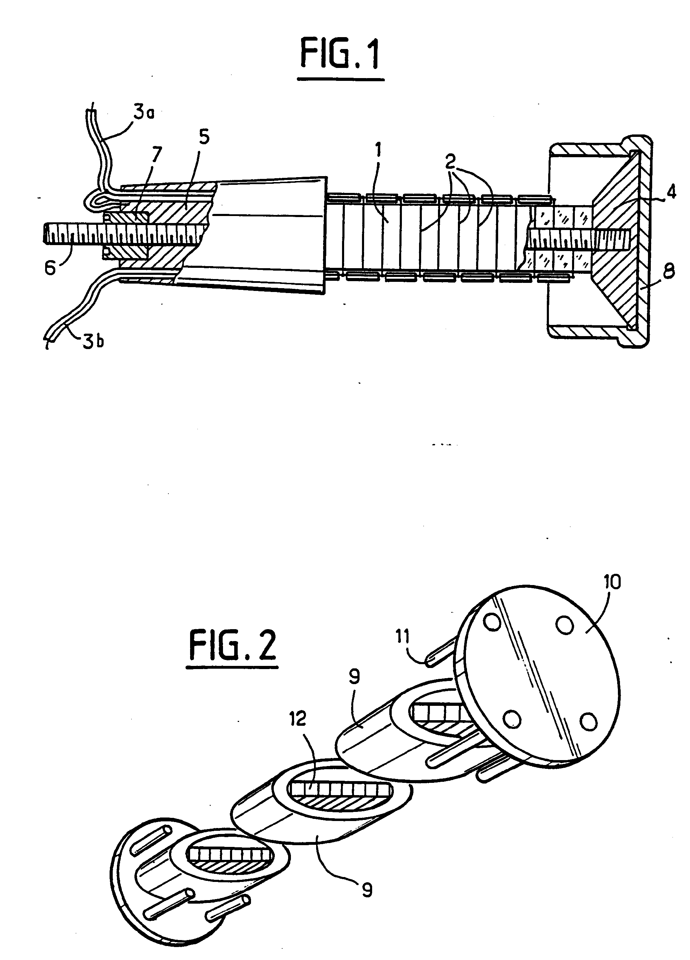

La figure 1 représente un transducteur piézo-électrique de type Tonpilz.

Ce transducteur comporte un moteur piézo-électrique qui est composé d'un empilement d'anneaux 1 en céramique piézo-électrique, qui sont séparés entre eux par des électrodes 2 qui sont connectées alternativement sur deux conducteurs électriques 3a et 3b, qui relient le transducteur à un oscillateur électronique non représenté.

L'empilement de céramiques est disposé entre un pavillon 4 et une contremasse 5.

Une tige axiale 6 est vissée dans le pavillon 4. Elle passe dans un alésage axial foré à travers les anneaux 1, les électrodes et la contremasse 5. Un écrou 7 est vissé sur l'extrémité libre de la tige 6 qui est filetée et le serrage de l'écrou 7 permet de mettre la tige 6 en tension et de maintenir les anneaux en céramique constamment comprimés.

La face avant du pavillon 4, qui est en contact avec l'eau est recouverte d'une enveloppe 8, en un matériau acoustiquement transparent, par exemple en caoutchouc.

De tels transducteurs de type Tonpilz sont bien connus et ils sont utilisés couramment pour composer les émetteurs sonars utilisés pour émettre des ondes acoustiques dans l'eau.

L'empilement de céramiques piézo-électriques forme un barreau qui oscille longitudinalement lorsqu'il est excité électriquement.

La figure 2 représente un transducteur de type dit "flextensional". Ce transducteur comporte plusieurs enveloppes rigides creuses et identiques 9, ayant une section droite elliptique, qui sont disposées bout à bout entre deux flasques 10, reliés entre eux par des tiges 11.

Chaque enveloppe 9 contient un empilement 12 de plaquettes piézo-électriques. L'axe de l'empilement est confondu avec le grand axe de l'enveloppe elliptique.

Les plaquettes piézo-électriques alternent avec des électrodes qui sont reliées alternativement à l'un ou à l'autre de deux conducteurs qui sont connectés sur un oscillateur électronique, qui permet d'exciter les plaquettes. Les oscillations axiales des plaquettes sont transmises aux enveloppes 9 qui amplifient celles-ci et qui les transmettent à l'eau dans le cas d'un émetteur sonar.

Les empilements de plaquettes piézo-électriques alternant avec des électrodes, peuvent être remplacés par un barreau cylindrique ferromagnétique dans le cas de transducteurs magnétostrictifs.

La présente invention a pour objet des transducteurs électro-acoustiques de type Tonpilz ou de type "flextensional" comportant un empilement de plaquettes identiques qui permettent d'émettre une forte puissance sur des fréquences basses comprises entre 100 Hz et 10 KHz.

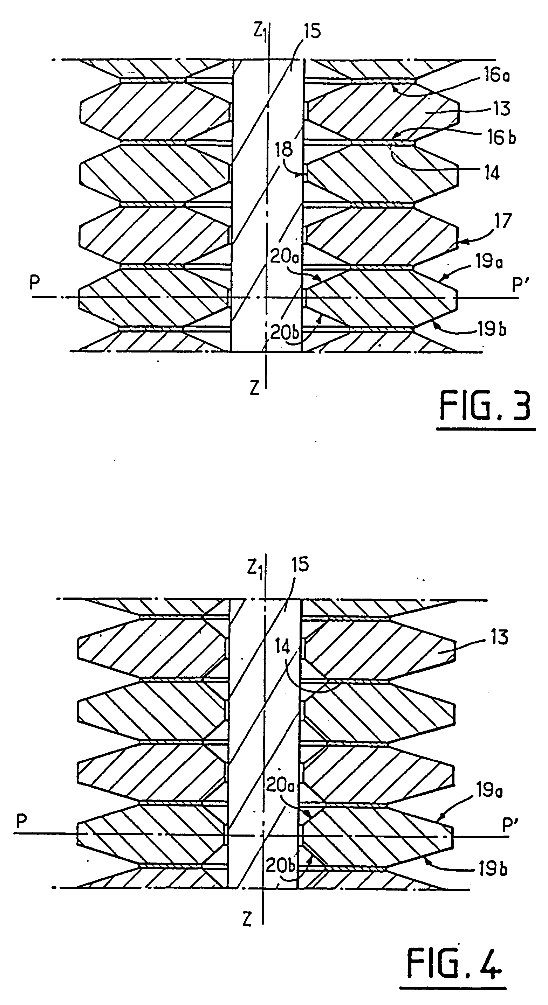

La figure 3 est une coupe axiale partielle d'un mode de réalisation d'un empilement de céramiques piézo-électriques constituant le moteur d'un transducteur selon l'invention de type Tonpilz ou un des moteurs d'un transducteurs de type "flextensional".

Suivant ce mode de réalisation, l'empilement est composé de plaquettes identiques 13 qui sont séparées entre elles par des électrodes 14, qui sont reliées à un oscillateur électronique par des conducteurs non représentés.

Chaque plaquette a la forme d'un anneau d'axe zz1 qui est percé d'un alésage axial à travers lequel passe une tige 15 destinée à être précontrainte en tension, pour maintenir les plaquettes pressées les unes contre les autres. Chaque plaquette 13 présente deux faces 16a et 16b perpendiculaires à l'axe zz1 qui sont en contact avec les deux faces d'une électrode 14 intercalée entre les deux plaquettes. Chaque plaquette présente, en outre, une périphérie externe 17 et une périphérie interne 18. Ces périphéries externe et interne sont deux surfaces cylindriques concentriques d'axe zz1.

Chaque plaquette comporte un plan de symétrie PP' perpendiculaire à l'axe zz1.

Suivant une caractéristique de l'invention, chaque plaquette 13 comporte à sa périphérie externe deux chanfreins 19a et 19b, qui sont symétriques par rapport au plan PP'.

Chaque plaquette comporte, en outre, à sa périphérie interne, deux autres chanfreins 20a et 20b également symétriques par rapport au plan PP'.

Les chanfreins 19a, 19b, 20a et 20b sont constitués par des surfaces tronconiques d'axe zz1.

Ainsi, les surfaces 16a et 16b perpendiculaires à l'axe zz1 qui servent de surface de contact entre deux plaquettes par l'intermédiaire d'une électrode, sont des méplats annulaires, dont la surface S1 est inférieure à la section droite maxima S2 de chaque électrode par un plan perpendiculaire à l'axe zz1.

Il en résulte que la fréquence de résonance F de l'empilement est faible car cette fréquence est inversement proportionnelle à la racine carrée de l'élasticité de l'empilement, laquelle élasticité est inversement proportionnelle à la surface de contact entre les plaquettes successives. Par contre, la puissance émise par l'empilement est proportionnelle au volume de l'empilement qui est égal à la longueur de celui-ci, multiplié par une section transversale intermédiaire entre la section droite maxima des plaquettes et la surface de contact entre électrodes.

Comparées à des plaquettes annulaires de même diamètre externe et interne qui ne sont pas chanfreinées, des plaquettes chanfreinées par des surfaces tronconiques coaxiales avec l'empilement permettent donc d'obtenir, avec une puissance sensiblement la même, une fréquence d'émission plus basse ou pour une même fréquence une puissance d'émission plus élevée, le gain de puissance pouvant atteindre 50%.

La figure 3 représente un mode de réalisation préférentiel dans lequel les électrodes 14 ne recouvrent pas les surfaces chanfreinées 19a, 19b, 20a, 20b. Elles recouvrent uniquement les surfaces 16a et 16b de contact entre plaquettes successives. Cette disposition préférentielle des électrodes présente l'avantage que les lignes de champ électrique entre les électrodes positives et négatives placées de part et d'autre d'une plaquette ont une plus grande longueur que dans le cas de plaquettes en forme d'anneaux cylindriques et d'électrodes s'étendant sur toute la section droite des plaquettes, ce qui réduit les risques de claquage en fonctionnement par une décharge contournant les plaquettes et permet donc d'utiliser une tension d'excitation plus élevée donc d'augmenter encore la puissance.

En variante, les électrodes 14 peuvent couvrir les méplats et tout ou partie des chanfreins 19a, 19b

La figure 4 représente une coupe axiale partielle d'un autre mode de réalisation d'un transducteur selon l'invention qui comporte également un empilement de céramiques piézo-électriques 13 séparées par des électrodes 14. Les céramiques 13 sont des anneaux percés d'un alésage axial dans lequel passe une tige 15 de précontrainte. La périphérie externe de chaque anneau est chanfreinée par deux surfaces tronconiques 19a, 19b centrées sur l'axe zz1 et symétriques par rapport à un plan PP' perpendiculaire à l'axe zz1. La périphérie interne de chaque anneau est également chanfreinée par deux surfaces tronconiques 20a, 20b symétriques par rapport au plan PP'.

La seule différence entre les modes de réalisation représentés sur les figures 3 et 4 réside dans le fait que dans le cas de la figure 3, les chanfreins 20a et 20b sont symétriques des chanfreins 19a et 19b par rapport à une surface cylindrique verticale médiane tandis que dans le cas de la figure 4, ils ne sont pas symétriques.

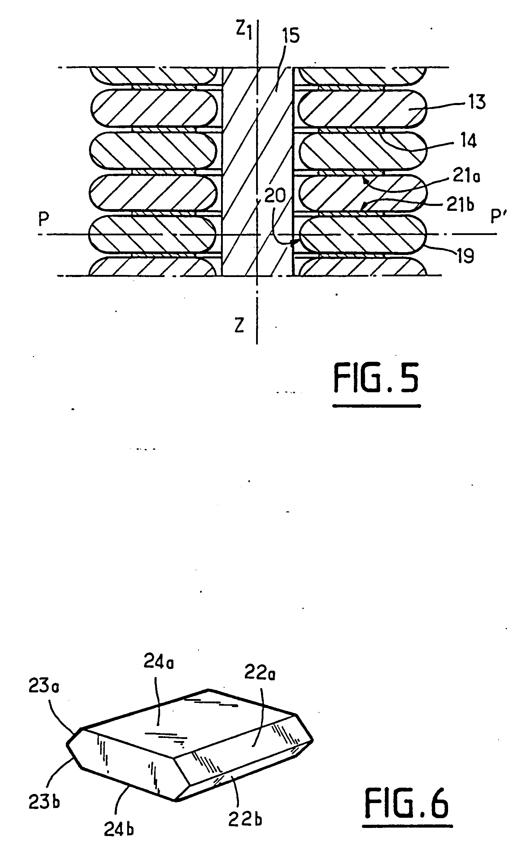

La figure 5 représente un autre mode de réalisation d'un empilement de céramiques piézo-électriques 13 alternant avec des électrodes 14 et constituant le moteur actif d'un transducteur électro-acoustique utilisé comme émetteur de sonar.

Les électrodes 13 ont la forme générale d'anneaux percés d'un alésage axial dans lequel passe une tige 15 de précontrainte. Les arêtes supérieure et inférieure de la périphérie externe de chaque anneau sont tronquées par une surface torique 19 centrée sur l'axe zz1. De même, les arêtes supérieure et inférieure de la périphérie interne de chaque anneau sont tronquées par une surface torique 20 centrée sur l'axe zz1. Ainsi, chaque anneau présente la forme générale d'un tore aplati comportant deux méplats annulaires 21a et 21b sur ses faces supérieure et inférieure, qui servent de face d'appui des anneaux l'un sur l'autre, par l'intermédiaire des électrodes annulaires 14, dont la surface correspond à celle des méplats 21a et 21b.

Soit S1 la surface des méplats et des électrodes et S2 la section transversale maxima d'un anneau par le plan de symétrie PP'.

Des expériences réalisées en faisant varier le rapport S1/S2 ont montré que l'on obtenait des émetteurs en basse fréquence ayant une puissance accrue d'environ 50% lorsque le rapport S1/S2 est inférieur à 0,8.

Les figures 3, 4 et 5 représentent des modes de réalisation d'empilements de plaquettes ayant la forme d'anneaux qui est la forme la plus courante.

Il est cependant précisé que la présente invention ne se limite pas à des plaquettes circulaires. Elle peut également s'appliquer à des plaquettes rectangulaires ou carrées ou polygonales, dont on chanfreine alors les arêtes supérieure et inférieure de deux côtés opposés ou des quatre côtés de la périphérie externe et dont on peut également chanfreiner la périphérie interne si ces plaquettes sont percées d'un alésage pour le passage d'une tige de précontrainte.

La figure 6 représente un exemple d'une plaquette rectangulaire dont deux côtés opposés sont tronqués chacun par deux chanfreins, respectivement les chanfreins 22a et 22b et 23a et 23b, de sorte que chaque plaquette s'appuie sur deux autres par deux méplats 24a et 24b, dont la surface S1 est inférieure à la plus grande section transversale S2.

Les exemples de réalisation qui précèdent se réfèrent à des empilements de plaquettes piézo-électriques alternant avec des électrodes.

On utilise également des transducteurs magnétostrictifs qui comportent un barreau en un matériau ferromagnétique qui est excité par une bobine.

Il est précisé que la présente invention peut s'appliquer également à ce type de transducteurs. Dans ce cas, le barreau ferromagnétique est découpé en tranches ou plaquettes et chaque plaquette comporte, sur ses faces qui sont en contact avec deux autres plaquettes, des méplats dont la surface est inférieure à la section transversale maxima du barreau, de sorte que l'on augmente ainsi l'élasticité du barreau sans réduire sensiblement le volume total, ce qui permet donc d'émettre sur une basse fréquence, tout en ayant une forte puissance d'émission.

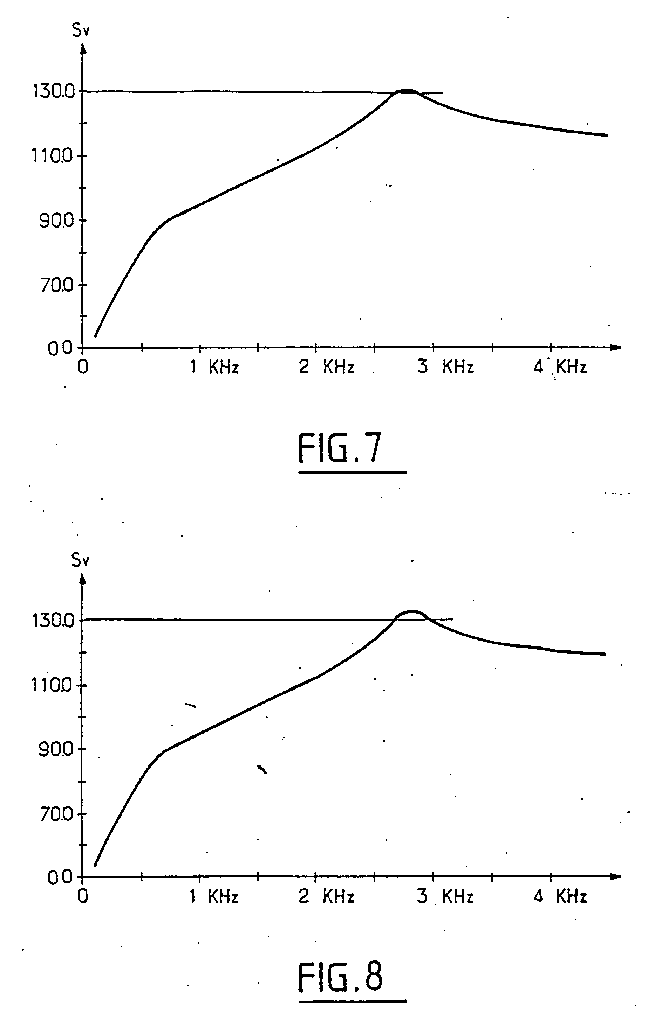

Les figures 7 et 8 représentent des mesures comparatives. Ces deux figures représentent en abscisses les fréquences comprises entre 0 et 4 KHz et en ordonnées la sensibilité en décibels par volts (référence $1\mu Pa$ à 1 mètre).

La figure 7 montre la sensibilité obtenue avec un transducteur de type tonpilz classique, c'est-à-dire un transducteur comportant des céramiques piézo-électriques annulaires.

On voit que l'on obtient une sensibilité maxima de l'ordre de 131 décibels pour une fréquence de l'ordre de 2,8 KHz.

La figure 8 montre les résultats obtenus avec le même transducteur de type Tonpilz en remplaçant les céramiques annulaires par des céramiques comportant des méplats ayant une surface S1 égale à 0,8 fois la section transversale maxima des céramiques.

La courbe obtenue montre que l'on obtient une sensibilité maxima de l'ordre de 133 dB pour une fréquence de résonance inchangée. Le gain de 2 dB correspond à un gain de puissance acoustique de l'ordre de 50% pour une même tension électrique.

**Revendications**

1. Procédé pour augmenter la puissance émise par un transducteur électro-acoustique à basse fréquence composé d'un empilement de plaquettes électro-acoustiques, caractérisé en ce que l'on tronque les arêtes desdites plaquettes, de telle sorte que les surfaces de contact de chaque plaquette avec celles qui lui sont juxtaposées dans l'empilement sont réduites à deux méplats (16a, 16b, 21a, 21b, 24a, 24b) dont la surface (S1) est inférieure à la section transversale maxima (S2) de chaque plaquette.

2. Procédé selon la revendication 1, caractérisé en ce que le rapport entre la surface (S1) desdits méplats et la section transversale maxima (S2) desdites plaquettes est inférieur à 0,8.

3. Procédé selon l'une quelconque des revendications 1 et 2 pour accroître la puissance émise par un transducteur électro-acoustique à basse fréquence composé d'un empilement de céramiques annulaires piézo-électriques (13) alternant avec des électrodes annulaires (14), caractérisé en ce que l'on tronque la périphérie externe et la périphérie interne de chaque plaquette par des surfaces tronconiques (19a, 19b, 20a, 20b) ou toriques (19, 20), de sorte que les surfaces de contact de chaque plaquette avec celles qui lui sont juxtaposées sont réduites à deux méplats annulaires (21a, 21b) et on intercale entre les méplats de deux plaquettes voisines une électrode annulaire (14) ayant la même surface que lesdits méplats.

4. Transducteur électro-acoustique à basse fréquence du type comportant un empilement de plaquettes électro-acoustiques identiques (13) formant un barreau qui vibre longitudinalement lorsqu'il est excité électriquement, caractérisé en ce que les arêtes dedites plaquettes sont tronquées de telle sorte que les surfaces de contact de chaque plaquette avec celles qui lui sont juxtaposées dans ledit empilement, sont constituées de deux méplats (16a, 16b, 21a, 21b, 24a, 24b), dont la surface (S1) est inférieure à la section transversale maxima (S2) desdites plaquettes de telle sorte que la puissance émise par se transducteur électro-acoustique est augmentée.

**5.** Transducteur électro-acoustique à basse fréquence selon la revendication 4, comportant un empilement d'anneaux de céramiques piézo-électriques identiques (13) séparées par des électrodes (14) et comportant un alésage axial traversé par une tige de précontrainte (15), caractérisé en ce que la périphérie externe (17) et la périphérie interne (18) de chaque anneau est tronquée, de sorte que chaque anneau présente sur chacune de ses faces de contact un méplat annulaire (16a, 16b), dont la surface (S1) est inférieure à la section transversale maxima (S2) de chaque anneau.

**6.** Transducteur électro-acoustique selon la revendication 5, caractérisé en ce que chaque anneau de céramique (13) comporte à sa périphérie externe, deux chanfreins (19a, 19b) et à sa périphérie interne deux chanfreins (20a, 20b), lesquels chanfreins sont constitués par des surfaces tronconiques centrées sur l'axe (zz1), commun auxdits anneaux.

**7.** Transducteur électro-acoustique selon la revendication 5, caractérisé en ce que chaque anneau de céramique (13) comporte, à sa périphérie externe et à sa périphérie interne une surface torique (19, 20), centrée sur l'axe (zz1), commun auxdits anneaux.

**8.** Transducteur électro-acoustique selon la revendication 4, de type magnétostrictif comportant un barreau ferromagnétique, caractérisé en ce que ledit barreau est divisé en tranches et les faces de contact de chaque tranche avec les tranches qui sont juxtaposées sont constituée par des méplats dont la surface (S1) est inférieure à la section transversale (S2) dudit barreau.

**Patentansprüche**

**1.** Verfahren zur Leistungserhöhung eines elektro-akustischen Niedrigfrequenz-Meßwandlers, bestehend aus einem Stapel von elektro-akustischen Plättchen, dadurch gekennzeichnet, daß man die Kanten der besagten Plättchen abstumpft, so daß sich ihre Kontaktflächen mit denjenigen der ihnen im Stapel überlagerten Plättchen auf zwei Anflachungen (16a, 16b, 21a, 21b, 24a, 24b) beschränken, deren Fläche (S1) kleiner ist, als der maximale Querschnitt (S2) der einzelnen Plättchen.

**2.** Verfahren nach Anspruch 1, dadurch gekennzeichnet, daß das Verhältnis zwischen der Fläche (S1) der besagten Anflachungen und der maximale Querschnitt (S2) der besagten Plättchen kleiner ist als 0,8.

**3.** Verfahren nach einem der Ansprüche 1 und 2 zur Verstärkung der von einem elektro-akustischen Niedrigfrequenz-Meßwandler abgegebenen Leistung, bestehend aus einem Stapel ringförmiger, piezoelektrischer Keramiken (13), die sich mit ringförmigen Elektroden (14) abwechseln, dadurch gekennzeichnet, daß man die externe Peripherie und die interne Peripherie der einzelnen Plättchen durch kegelstumpfartige (19a, 19b, 20a, 20b) oder wulstförmige (19, 20) Flächen abstumpft, so daß die Kontaktflächen der einzelnen Plättchen mit den ihnen überlagerten Kontaktflächen auf zwei ringförmige Anflachungen (21a, 21b) beschränkt werden, und daß man zwischen den Anflachungen zweier benachbarter Plättchen eine ringförmige Elektrode (14) einfügt, die die gleiche Fläche aufweist, wie die besagten Anflachungen.

**4.** Elektro-akustischer Niedrigfrequenz-Meßwandler mit einem Stapel aus identischen, elektro-akustischen, Plättchen (13), die einen Stab bilden, der in Längsrichtung vibriert, wenn er elektrisch erregt wird, dadurch gekennzeichnet, daß die Kanten der besagten Plättchen abgestumpft sind, so daß die Kontaktflächen der einzelnen Plättchen mit den ihnen im Stapel überlagerten Kontaktflächen aus zwei Anflachungen (16a, 16b, 21a, 21b, 24a, 24b) bestehen, deren Fläche (S1) kleiner ist, als der maximale Querschnitt (S2) der besagten Plättchen, so daß die vom elektro-akustischen Meßwandler abgegebene Leistung erhöht wird.

**5.** Elektro-akustischer Niedrigfrequenz-Meßwandler nach Anspruch 4, mit einem Stapel aus identischen, von Elektroden (14) getrennten, piezoelektrischen Keramikringen (13), und mit einer Axialbohrung zur Durchführung eines Vorspannungsstabs (15), dadurch gekennzeichnet, daß die externe Peripherie (17) und die interne Peripherie (18) der einzelnen Ringe abgestumpft sind, so daß jeder Ring auf jeder seiner Kontaktseiten eine ringförmige Anflachung (16a, 16b) aufweist, deren Fläche (S1) kleiner ist, als der maximale Querschnitt (S2) der einzelnen Ringe.

**6.** Elektro-akustischer Meßwandler nach Anspruch 5, dadurch gekennzeichnet, daß jeder Keramikring (13) an seiner externen Peripherie zwei Abschrägungen (19a, 19b) und an seiner internen Peripherie zwei Abschrägungen (20a, 20b) aufweist, die aus kegenstumpfartigen, auf die den besagten Ringen gemeinsamen Achse (zz1) zentrierten Flächen bestehen.

7. Elektro-akustischer Meßwandler nach Anspruch 5, dadurch gekennzeichnet, daß jeder Keramikring (13) an seiner externen Peripherie und an seiner internen Peripherie eine wulstförmige Fläche (19, 20) aufweist, die auf die den besagten Ringen gemeinsamen Achse (zz1) zentriert ist.

8. Elektro-akustischer Meßwandler nach Anspruch 4, magnetostriktiver Art, mit einem ferromagnetischen Stab, dadurch gekennzeichnet, daß der besagte Stab in Scheiben unterteilt ist, und daß die Kontaktflächen der einzelnen Scheiben mit den überlagerten Scheiben aus Anflachungen bestehen, deren Fläche (S1) kleiner ist, als der Querschnitt (S2) des besagten Stabs.

**Claims**

1. A process to increase the power emitted by a low frequency electroacoustic transducer made of a stack of electroacoustic plates, wherein the edges of said plates are truncated, so that contact surfaces of each plate with the adjacent plates in the stack are reduced to two flat parts (16a, 16b, 21a, 21b, 24a, 24b) whose surface (S1) is smaller than the maximum cross section (S2) of each plate.

2. A process according to claim 1, wherein the relationship between the surface (S1) of said flat parts and the maximum cross section (S2) said plates is smaller than 0.8.

3. A process according to any of claims 1 and 2 to increase the power emitted by a low frequency electroacoustic transducer made of a piezoelectric annular ceramics stack (13) alternating with annular electrodes (14), wherein the external periphery and internal periphery of each plate is truncated by truncated surfaces (19a, 19b, 20a, 20b) or toric surfaces (19, 20) so that the surfaces of contact of each plate with the adjacent plates are reduced to two annular flat parts (21a, 21b) and between the flat parts of two adjacent plates an annular electrode (14) having the same surface as said flat parts is intercalated.

4. Low frequency electroacoustic transducer of the type comprising a stack of similar electroacoustic plates (13) forming a bar which vibrates longitudinally when it is electrically energized, wherein the surfaces of contact of each plate with the adjacent plates in said stack, are made of two flat parts (16a, 16b, 21a, 21b, 24a, 24b) whose surface (S1) is smaller than the maximum cross section (S2) of said plates.

5. Low frequency electroacoustic transducer according to claim 4, comprising a stack of similar rings of piezoelectric ceramics (13) separated by the electrodes (14) and comprising an axial boring crossed by a prestressing stem (15), wherein the external periphery (17) and the internal periphery (18) of each ring is truncated, so that each ring presents on each of contact face an annular flat part (16a, 16b), whose surface (S1) is smaller than the maximum cross section (S2) of each ring.

6. Electroacoustic transducer according to claim 5, wherein each ceramics ring (13) comprises at its external periphery, two chamfers (19a, 19b) and at its internal periphery two chamfers (20a, 20b), which chamfers are constituted by the truncated surfaces centered on axis (zz1), common to the said rings.

7. Electroacoustic transducer according to claim 5, wherein each ceramics ring (13) comprises, at its external periphery and at its internal periphery a toric surface (19, 20), centered on the axis (zz1), common to said rings.

8. Electroacoustic transducer according to claim 4, of the magnetostrictive type comprising a ferromagnetic bar, wherein said bar is divided into parts and the contact face of each section with the adjacent sections consists of flat parts , whose surface (S1) is smaller than the cross section (S2) of said bar.

# FIG.1

# FIG.2

FIG. 3

FIG. 4

FIG.5

FIG.6

FIG.7

FIG.8